# EUROPÄISCHE PATENTSCHRIFT

(11) **EP 1 835 684 B1**
(45) Veröffentlichungstag und Bekanntmachung des Hinweises auf die Patenterteilung: **17.05.2017**
(21) Anmeldenummer: 07000795.0
(22) Anmeldetag: 16.01.2007
(51) Int. Cl.: H04L 27/36, H03F 1/32, H03F 3/24

(54) **Sendeeinrichtung und Verfahren mit digitaler Regelung einer kartesischen Rückkopplungsschleife**
Transmitter and method with digital control of a Cartesian feedback loop
Emetteur et procédé à contrôle numérique d'une boucle cartésienne

(30) Priorität: 17.03.2006 DE 102006012464; 18.05.2006 DE 102006023441
(43) Veröffentlichungstag der Anmeldung: 19.09.2007
(73) Patentinhaber: Rohde & Schwarz GmbH & Co. KG, 81671 München (DE)
(72) Erfinder: Lipp, Friedrich, 5322 Hof bei Salzburg (AT)
(74) Vertreter: Körfer, Thomas

(56) Entgegenhaltungen:
- WO-A1-01/05026
- WO-A1-02/17586
- US-A- 6 081 698

## Beschreibung

Die Erfindung betrifft eine Vorrichtung und ein Verfahren zur digitalen Regelung einer Sendeeinrichtung. Die Sendeeinrichtung umfasst einen Quadraturmodulator und einen Leistungsverstärker, der durch eine so genannte kartesische Rückkopplungsschleife (cartesian feedback) mit einem Quadraturdemodulator linearisiert ist.

Eine analoge Vorrichtung nach dem Oberbegriff des Anspruchs 1 geht beispielsweise aus der WO 01/24467 A2 hervor. Bei der in dieser Druckschrift beschriebenen Sendeeinrichtung wird ein Basisband-Eingangssignal einem Quadraturmodulator zugeführt, welcher eine Quadraturmodulation der Quadraturphase- und der Inphase-Komponente des komplexen Eingangssignals generiert. Die Leistungsverstärkung des Sendesignals erfolgt in einem dem Quadraturmodulator nachgeschaltetem Leistungsverstärker. Zum Ausgleich der Nichtlinearität dieses Leistungsverstärkers ist eine Rückkopplungsschleife vorgesehen, die nach dem Verfahren des cartesian feedback eine Linearisierung des Leistungsverstärkers vorsieht. In dieser Rückkopplungsschleife befindet sich ein Quadraturdemodulator, der das rückgekoppelte Signal in eine rückgekoppelte Quadraturphase-Komponente und eine rückgekoppelte Inphase-Komponente demoduliert. Die rückgekoppelte Inphase-Komponente wird zusammen mit der Inphase-Komponente des Eingangssignals einem dem Quadraturmodulator vorgeschalteten ersten Differenzverstärker zugeführt. Entsprechend wird die rückgekoppelte Quadraturphase-Komponente zusammen mit der Quadraturphase-Komponente des Eingangssignals einem zweiten Differenzverstärker zugeführt. Durch einen Vergleich der rückgekoppelten Signale oder Ist-Größen mit den vom DSP eingespeisten Signalen oder Soll-Größen werden die Nichtlinearitäten des eingesetzten Leistungsverstärkers ausgeglichen.

Darüber hinaus wird bei der WO 01/24467 A2 ein Phasenschieber so eingestellt, dass das rückgekoppelte Signal phasenrichtig in die Schleife eingekoppelt wird. Zur Einstellung des Phasenwinkels wird in der WO 01/24467 A2 vorgeschlagen, während der ersten drei Zyklen des Sendeintervalls nur ein I-Signal zu senden. Bei diesem Betrieb wird die Rückkopplungsschleife am Ausgang des Quadraturdemodulators unterbrochen und das Ausgangssignal des Quadraturdemodulators wird gemessen. Bei dem vorgegebenen Eingangssignal kann aus dem Realteil und dem Imaginärteil des Ausgangssignals des Quadraturdemodulators der einzustellende Phasenwinkel berechnet werden.

In der WO 01/24472 A1 wird noch vorgeschlagen, einen optionalen Feinabgleich durchzuführen. Dabei werden die Gleichspannungsquellen zur Kompensation der Gleichspannungskomponenten des Quadraturdemodulators so eingestellt, dass sich an einem Leistungsdetektor eine minimale Leistung ergibt. In einem zweiten Schritt wird die Gleichspannungskomponente des Quadraturmodulators eingestellt, indem die weiteren Gleichspannungsquellen so eingestellt werden, dass der verbleibende Gleichspannungsanteil in der Rückkopplungsschleife an den betreffenden Verstärkern auf Null reduziert wird. Bei den in den Dokumenten WO 01/24467 A2 und WO 01/24472 A1 beschriebenen kartesischen Rückkopplungsschleifen wird jedoch bei der Einkopplung des Leistungsverstärkersignals in die Antenne ein Zirkulator eingesetzt der Reflektionen und andere Störsignale der Antenne zur Vermeidung einer Wiedereinkopplung in die kartesische Schleife über einen Abschlusswiderstand ableitet.WO 02/17586 offenbart ein Verfahren zur Vorverzerrung eines Signals, das in einem nichtlinearen Leistungsverstärker verzerrt wird, mithilfe einer kartesischen Regelung. Die Vorverzerrung ist invers zur Verzerrung im nichtlinearen Leistungsverstärker und wird aus der Differenz des zu sendenden Signals und des zugehörigen verstärkten und rückgekoppelten Signals dadurch ermittelt, dass für die Vorverzerrung des Signals ein in einem Speicher abgelegter Vorverzerrungsfaktor in Abhängigkeit des ermittelten Differenz-Wertes bestimmt wird. Insbesondere liegt keine kartesische Regelung mit einem Regler vor, der eine integrierende Regler-Charakteristik aufweist.

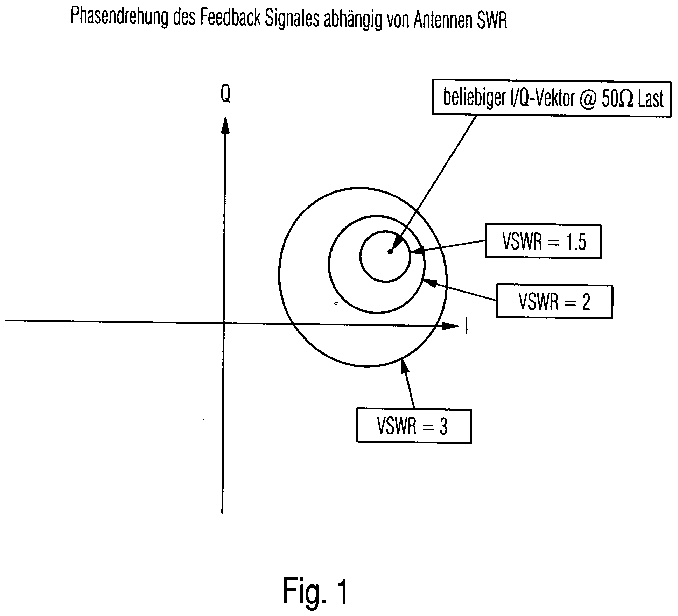

Fig. 1 zeigt die Phasendrehung des Rückkopplungssignals in Abhängigkeit vom Stehwellenverhältnis SWR der Antenne. Die Darstellung in Fig. 1 zeigt den originalen, d.h. den gesendeten Phasenwert bei 50 Ohm Antennenabschluss mit einem Punkt und den im Rückkopplungszweig empfangenen Phasenwert und Amplitudenwert durch jeweilige Kreise zu unterschiedlichen Stehwellenverhältnissen. Der Einfluss des Fehlabschlusses der Antenne auf den Rückkopplungszweig kann durch den Zirkulator zwar vermieden werden. Der Zirkulator erfordert jedoch einen hohen Kostenaufwand.

Der Erfindung liegt deshalb die Aufgabe zugrunde, eine Vorrichtung und ein Verfahren zur Realisierung einer Sendeeinrichtung mit einem Leistungsverstärker, welcher nach dem Prinzip des cartesisian feedback linearisiert ist, bereitzustellen, bei welchem es möglich ist, auf den Zirkulator zu verzichten.

Die Aufgabe wird durch die kennzeichnenden Merkmale des Vorrichtungsanspruchs 1 und des Verfahrensanspruchs 10 in Verbindung mit den gattungsbildenden Merkmalen gelöst.

Der Erfindung liegt die Erkenntnis zugrunde, dass durch eine digitale Realisierung die Auswirkungen von Antennenreflektionen schnell ausgeregelt werden können.

In einer vorteilhaften Weiterbildung der Erfindung kann die Verarbeitungseinheit zur digitalen Regelung eine Einheit zur Interpolation der Inphase-Komponente und zur Interpolation der Quadraturphase-Komponente aufweisen, um eine Vielzahl von Intersymbolwerten zu erzeugen und durch die Erzeugung von Zwischensamplewerten die Samplingrate zu erhöhen.

In einer weiteren vorteilhaften Weiterbildung der Erfindung kann die Verarbeitungseinheit zur digitalen Regelung eine erste Korrektureinheit zur Korrektur des durch Drift, Temperaturänderung, Alterung ect. veränderlichen Gleichspannungsversatzes der Inphase-Komponente des Quadraturdemodulators und zur Korrektur des Gleichspannungsversatzes der Quadraturphase-Komponente des Quadraturdemodulators aufweisen.

In einer weiteren vorteilhaften Weiterbildung der Erfindung kann die Verarbeitungseinheit zur digitalen Regelung eine Regeleinheit aufweisen, welche die Differenz der interpolierten Inphase-Komponente und der korrigierten Inphase-Komponente am Ausgang des Quadraturdemodulators und die Differenz der interpolierten Quadraturphase-Komponente und der korrigierten Quadraturphase-Komponente des Quadraturdemodulators als Eingangssignal erhält und daraus eine proportionale Regelgröße erzeugt.

In einer weiteren vorteilhaften Weiterbildung der Erfindung kann die Verarbeitungseinheit zur digitalen Regelung einen Integrator aufweisen, welcher das Ausgangssignal der ersten Regeleinheit als Eingangssignal erhält und zu dem zu sendenden Signal aufaddiert bzw. akkumuliert.

In einer weiteren vorteilhaften Weiterbildung der Erfindung kann die Verarbeitungseinheit zur digitalen Regelung eine Phasenrotationseinheit aufweisen, welche das Ausgangssignal des Integrators einer Phasenrotation unterwirft.

In einer weiteren vorteilhaften Weiterbildung der Erfindung kann die Verarbeitungseinheit zur digitalen Regelung eine weitere Korrektureinheit zur Korrektur des Gleichspannungsversatzes der Inphase-Komponente des Quadraturmodulators und zur Korrektur des Gleichspannungsversatzes der Quadraturphase-Komponente des Quadraturmodulators aufweisen.

Bei einem Verfahren zum Betreiben der Sendeeinrichtung werden die folgende Verfahrensschritte ausgeführt:
- Bestimmung eines Phasenkorrekturwertes aus der korrigierten Inphase-Komponente des Quadraturdemodulators und der korrigierten Quadraturphase-Komponente des Quadraturdemodulators, und
- Korrektur der zu sendenden Inphase-Komponente und der zu sendenden Quadraturphase-Komponente um den Phasenkorrekturwert. Dabei erfolgt erfindungsgemäß die Verarbeitung digital.

Die digitale Realisierung der Regelung erlaubt die Einsparung des Zirkulators. Die digitale Regelung mit heute erhältlichen Bauteilen erlaubt eine extrem schnelle Regelung und Phasendetektion, welche in der analogen Realisierung nicht erreicht wird. Zudem kann die Regelschleife jederzeit problemlos geschlossen und geöffnet werden, um die stabile Rückkoppelbedingung zu gewährleisten.

Durch die digitale Realisierung der Regelung ergeben sich neben dem bekannten Vorteil, dass eine Reihe weiterer analoger Bauteile eingespart werden kann, Vorteile in der Ansteuerung des Regelungssystems auf die im Folgenden detailierter eingegangen wird.

Ein weiterer Vorteil ist, dass mit der digitalen Regelung leichter auf bestimmte Betriebszustände des Senders eingegangen werden kann. So kann z.B. im Falle einer Mitkopplung, diese detektiert und von einem geregelten in einen ungeregelten Modus umgeschalten werden. Regelungsparameter können in Form von Tabellen vorberechnet in Speichern abgelegt werden.

Ein weiterer Vorteil der digitalen Realisierung der Regelung ist, dass zeitlich bedingte Änderungen bzw. der Ausfall von Bauteilen leicht in der Ansteuertung berücksichtigt werden können. So kann z.B. auch in einem äussersten Fall eines Antennenbruches von einem geregelten Modus auf einen direkten Modus umgeschaltet und danach der Sender in seiner Leistung reduziert werden.

Ein Phasenkorrekturwert kann aus der gemessenen Quadraturphase-Komponente unter Berücksichtigung der zusätzlich gemessenen Inphase-Komponente durch eine Arcus-Tangens-Beziehung unmittelbar bestimmt werden. Die den Messwerten zugeordnete Phasenkorrekturwerte können in einem Speicher tabelliert sein (look-up-Tabelle) und ohne weitere Berechnung unmittelbar abgelesen werden. Eine alternative Möglichkeit zur Bestimmung des optimalen Phasenkorrekturwertes besteht in einem Versuchs- und Irrtumsverfahren, bei welchem der Phasenwinkel versuchsweise während eines Empfangsintervalls geringfügig verändert wird und in dem nachfolgenden Sendeintervall durch Messen der Quadraturphase-Komponente mit dem vorstehend beschriebenen Referenzsignal ermittelt wird, ob der neu eingestellte Wert ein besseres Resultat erbringt. Ist dies der Fall, so wird der Phasenwinkel im nachfolgenden Empfangsintervall in diese Richtung weiter verändert.

Ein Ausführungsbeispiel der Erfindung wird nachfolgend unter Bezugnahme auf die Zeichnung näher beschrieben. In der Zeichnung zeigen:
- Fig. 1: ein Diagramm zur Veranschaulichung des Einflusses des Antennenabschlusses auf das Rückkopplungssignal;
- Fig. 2: ein Blockschaltbild eines Ausführungsbeispiels einer erfindungsgemäßen Sendeeinrichtung, welche eine digitale Regelung enthält, und
- Fig. 3: ein Blockdiagramm zur Erläuterung der erfindungsgemäßen Regelung.

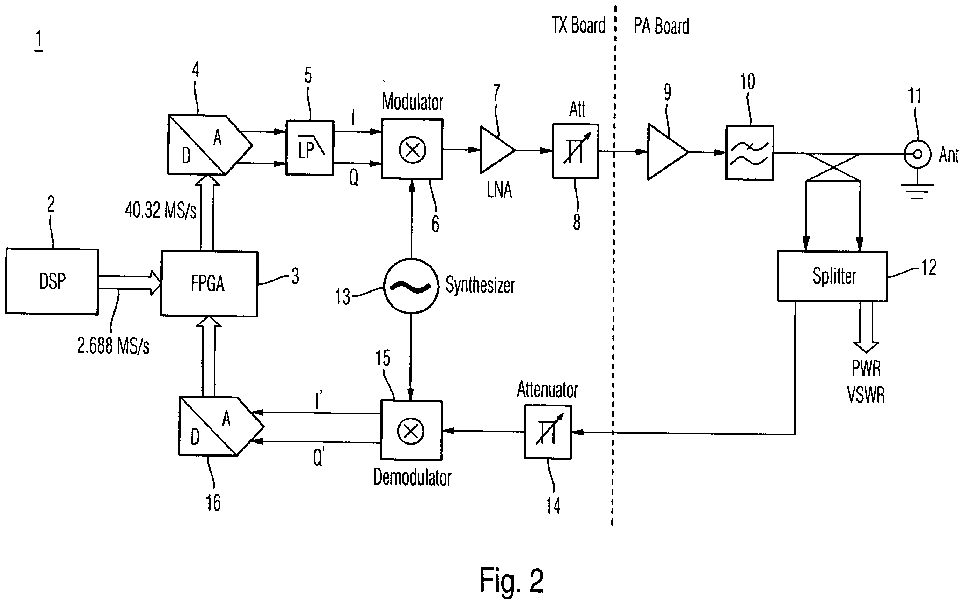

Fig. 2 zeigt eine erfindungsgemäße Sendeeinrichtung 1 einem prinzipiellen Blockschaltbild.

Ein digitaler Signalprozessor (DSP) 2 erzeugt ein komplexes Eingangssignal für einen FPGA (Free Programmable Gate Array), der eine Verarbeitungseinheit 3 für die digitale Regelung der Sendeeinrichtung realisiert. Das digitale Ausgangssignal des FPGA 3 wird an einen Digital-Analog-Wandler 4 weitergegeben, der das digitale Signal in ein analoges Signal umsetzt. Das analoge Ausgangssignal des Digital-Analog-Wandlers 4 wird mit dem Tiefpass 5 gefiltert und mittels eines Quadraturmodulators 6 und eines Oszillators oder Synthesizers 13 auf die entsprechende Übertragungsfrequenz oder ggf. zunächst auf eine Zwischenfrequenz moduliert.

Dem Quadraturmodulator 6 folgt ein rauscharmer Verstärker (Low Noise Amplifier) 7, in dem das Modulationssignal verstärkt auf einen Attenuator oder ein Abdämpfglied 8 gegeben wird. Das Ausgangssignal des Attenuators 8 wird auf den Leistungsverstärker 9 gegeben und verstärkt über einen Oberwellenfilter 10 an die Antenne 11 gegeben. Über einen Richtkoppler 12 wird gleichzeitig das Leistungsverstärkersignal nach dem Tiefpassfilter 10 für die Regelung ausgekoppelt.

Das Leistungsverstärkersignal wird über einen zweiten Attenuator oder Abdämpfer 14 an einen Quadraturdemodulator 15 weitergeleitet. Der Leistungsverstärker 9, das Oberwellenfilter 10 und der Richtkoppler 12 befinden sich vorzugsweise auf einem separaten PA-Board, wobei das Leistungsverstärker-Ausgangssignal an die an das PA-Board angeschlossene Antenne 11 ausgegeben wird. Der Demodulator 15 wird ebenfalls von dem Synthesizer 13 gespeist und das über den Quadraturmodulator 6 und Leistungsverstärker 9 geführte Signal wird demoduliert und in seine Inphase- und Quadraturphase-Basisband-Komponenten zerlegt. Die digitalisierten Inphase- und Quadraturphase-Komponenten werden dann über einen Analog-Digital-Wandler 16 an die Verarbeitungseinheit 3 weitergegeben und dort digital verarbeitet, womit die Regelschleife geschlossen und eine digitale Regelung nach dem cartesian-feedback-Verfahren realisiert wird.

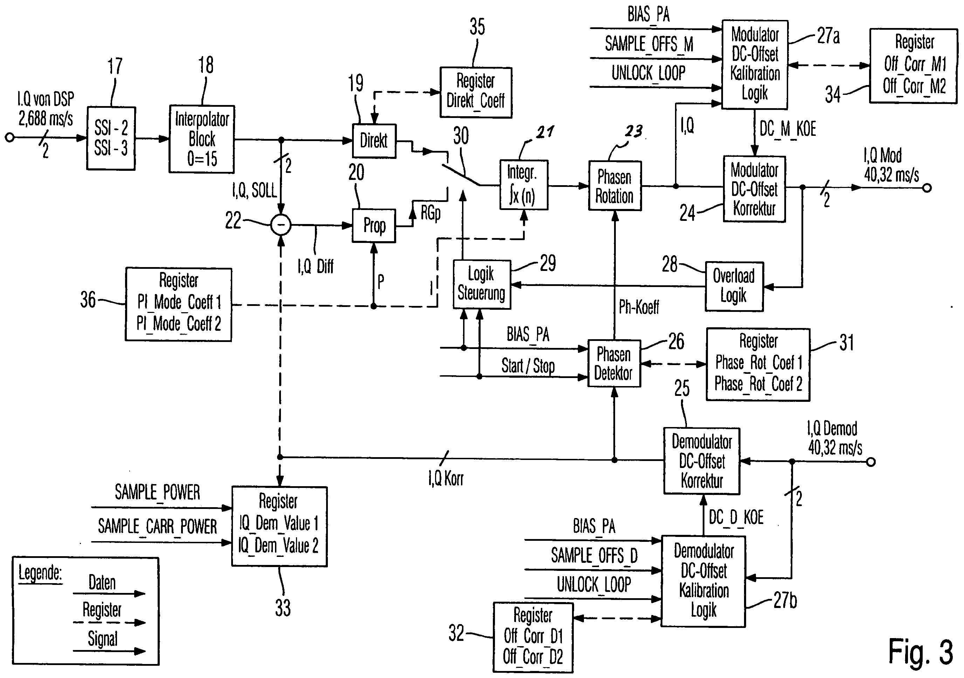

Fig. 3 zeigt den beispielhaften.internen Aufbau der Verarbeitungseinheit 3 zur digitalen Regelung der Sende- und Empfangseinrichtung, die z.B. als FPGP (Free Programmable Gate Array) implementiert sein kann. Das I- und Q-Signal wird über den SSI-Eingangspuffer 17 (Serial-Synchronized-Interface) an einen Interpolationsblock 18 weitergeleitet. Dort werden die digitalen Abtastwerte komplex interpoliert und an das ,Direkt Mode'-Modul 19 weitergegeben. Gleichzeitig werden die interpolierten komplexen Abtastwerte I, Q SOLL als Sollwerte an ein Differenzbildungsmodul (z. B. einen Subtrahierer) 22 weitergegeben. Das ,Direkt Mode'-Modul 19 leitet das Signal über ein Schaltelement 30 direkt an einen Integrator 21 weiter. Das Schaltelement 30 erhält als Eingangssignal an einem zweiten Eingang das Ausgangssignal eines ,Proportional-Mode'-Moduls 20, der einen Proportional-Regler enthält.

Das ,Direkt Mode'-Modul 19 arbeitet so, dass die eingehenden, zu sendenden I/Q-Sollwerte I, Q SOLL an den Ausgang und somit an den Eingang des Integrators 21 gewichtet durchgeschaltet werden. Die Gewichtung bzw. Skalierung erfolgt vorzugsweise je nach Frequenz bzw. Erfahrungswert aus dem vorangegangenen Regelbetrieb. Die Logiksteuerung im Logik-Block 26 legt fest, ob im direkten Mode oder im Proportional-Mode gearbeitet wird. Im geregelten Proportional-Mode wird dem Eingang des Integrators 21 die Regelgröße RG_{P} weitergegeben, welche die Regeldifferenz ausgehend von den Ausgangswerten I, Q Diff des Differenzbildungsmoduls 22 durch Multiplikation mit einem Proportionalitätsfaktor erzeugt. Jeder Inphase-Wert I Diff ergibt sich aus einer Differenz zwischen dem zu sendenden I-Wert I SOLL und dem bezüglich des Gleichspannungsversatzes korrigierten I-Wert I Korr des demodulierten I-Werts I Demod. Analog ergibt sich jeder Q-Wert Q Diff aus der Differenz zwischen dem zu sendenden Q-Wert Q SOLL und dem bezüglich des Gleichspannungsversatzes korrigierten Q-Wert Q Korr des demodulierten Q-Wertes Q Demod. Der ,Proportional-Mode'-Block 20 arbeitet also als Proportional-Regler. Im ,Direkt Mode' wird der Integrator 21 direkt mit den Ausgangsdaten des ,Direkt Mode'-Blocks 19 initiiert und dann laufend beschrieben.

Die von dem ,Proportional-Mode'-Block 20 erzeugte Regelgröße RG_{P} wird jedoch nur dann auf den Addierer 21 gegeben, wenn im geregelten ,Proportional-Mode' gearbeitet wird und dabei das Schaltelement die in Fig. 3 untere Schaltstellung einnimmt. Während der Einschaltphase oder in extremen Betriebszuständen, beispielsweise bei einer stark fehlangepassten Antenne, muss die geregelte Betriebsart verlassen werden und in den sogenannten ,Direkt Mode' umgeschaltet werden.

Das Ausgangssignal des Addierers 21 wird einem ,Phasen Rotation'-Block 23 zugeführt, der eine Phasenrotation des komplexen Signals ausführt und Phasendrehungen in der Regelschleife ausgleicht. Nach der Phasenkorrektur des komplexen Signals im ,Phasen Rotation'-Block 23 wird in der Korrektureinheit 24 eine Korrektur des Modulator Gleichsignalanteils durchgeführt und das komplexe Modulatorsignal als Signal ,I/Q Mod' an den Quadraturmodulator 6 ausgegeben.

Das komplexe Quadraturdemodulatorsignal ,I/Q Dem' aus dem Quadraturdemodulator 15 wird im 'Demodulator DC-offset Korrektur'-Block 25 von dem komplexen Gleichspannungsanteil des Quadraturdemodulators 15 bereinigt und in den ,Phasen Detektor'-Block 26, der eine Phasenmessung vornimmt, eingespeist. Der ,Phasen Detektor'-Block 26 liefert am Ausgang den Phasenkorrekturwert Ph-Koeff für den ,Phasen Rotation'-Block 23 zur Phasenkorrektur des komplexen Modulationssignals. Andererseits wird das um den Gleichspannungsanteil korrigierte demodulierte Signals, d.h. das Ausgangssignal des ,Demodulator DC-offset Korrektur'- Blocks 25, in den ,Differenzbildungs'-Block 22 eingespeist. Dieser Block 22 bildet die Differenz aus dem korrigierten komplexen Demodulatorsignal ,I/Q Korr' und dem komplexen Soll-Vorgabesignal, I/Q SOLL'.

Die verschiedenen Register 31 - 36 dienen zur Speicherung der verwendeten Parameter und Koeffizienten. Die Logiken 27 - 29 dienen zur Ansteuerung der verschiedenen Signalverarbeitungsblöcke, insbesondere des Umschaltelements 30, des ,Modulator DC-offset Korrektur'-Blocks 24 und des ,Demodulator DC-offset Korrektur'-Blocks 25. Wie in der Fig. 3 zu sehen, erhalten die Logik-Blöcke 27-29 Eingangssignale als Informations-, Parameter- und bitwertige Schaltsignale zur Ansteuerung der Signalverarbeitungsblöcke. Zum Beispiel empfängt der Block 27a die Parameter ,BIAS_PA', ,SAMPLE_OFFS_M', und ,UNLOCK_LOOP', wobei der Parameter BIAS_PA' anzeigt, ob die Versorgungsspannung am Leistungsverstärker 9 anliegt, der Parameter ,UNLOCK_LOOP' anzeigt, ob die Regelschleife geschlossen ist, und der Parameter ,SAMPLE_OFFS_M' den Abtastzeitpunkt für die Offset-Ermittlung angibt.

Die Funktion der digitalen Verarbeitungseinheit 3 basiert auf dem komplexen Eingangssignal des DSP 2, dem komplexen Demodulatorsignal und dem komplexen Modulatorsignal. Das eingespeiste Demodulatorsignal wird um einen vorher kalibrierten oder vermessenen Gleichspannungskorrekturwert korrigiert und an einen Differenzbildungsblock 22 geliefert. Der Differenzbildungsblock 22 erhält als zweites Eingangssignal das komplexe Interpolationssignal aus dem Interpolationsblock 18 als Sollsignal. Die gemessene Differenz aus dem interpolierten Sollsignal und dem vom Gleichspannungsfehler des Quadraturdemodulators 15 korrigierten, rückgekoppelten Istsignal wird auf den Proportional-Regler im ,Proportional-Mode'-Block 20 gegeben, wonach der Integrator 21 die Differenz Sample für Sample akkumuliert.

Das Ausgangssignals des Integrators 21 wird im Phasen-Rotations-Block 23 phasenrotiert und zur Korrektur des Modulator-Gleichspannungsoffsets im ,Modulator DC-Offset Korrektur'-Block 24 mit den Korrekturwerten DC_M_KOE für den Modulator-Gleichspannungsoffsets korrigiert, so dass am Ausgang des Modulators 6 ein Restträger-freies Übertragungssignal bereitgestellt werden kann.

Darüber hinaus kann auch das in der WO 01/24467 A2 beschriebene Einstellverfahren für den Phasenwinkel angewendet werden. Während des Hochrampens nur mit der Inphase-Komponente I wird die Rückkoppel-Phase gemessen und der Phasenrotator 23 eingestellt. Danach wird in den ,Proportional-Mode' durch das Schaltelement 30 umgeschaltet.

Wie in der WO 01/24472 A1 beschrieben, kann in dem im FPGA 3 realisierten Programm eine Feineinstellung oder Kalibration des Offsets vorgenommen werden. So kann mit der erfindungsgemäßen Vorrichtung auch das dort beschriebene Abgleichverfahren durchgeführt werden, bei dem der Offset während jedes Sendeburst geeicht wird. Bei dem Verfahren wird für die Dauer von z. B. 3 Datensymbolen ein Startsignal übertragen. In diesem Zeitinterval kann deshalb eine Messung oder Kalibration des Demodulator-Offsets mit dem ,Demodulator DC-Offset Kalibration Logik'-Block 27b durchgeführt werden. Auch der in der WO 01/24472 A1 beschriebene optionale Feinabgleich kann erfolgen. Mit Hilfe des ,Demodulator DC-Offset Kalibration Logik'-Blocks 27b wird dabei der Gleichspannungsversatz des Quadraturdemodulators 15 kompensiert und der Gleichspannungsversatz optimiert, wobei der Leistungsverstärker 9 abgeschaltet ist.

Danach erfolgt ein Abgleich des Gleichspannungsversatzes des Quadraturmodulators 6 mit Hilfe des 'Modulator DC-Offset Kalibration Logik'-Blocks 27, indem das Signal im Pfad zwischen dem Phasenrotationblock 23 und dem 'Modulator DC-Offset Korrektur'-Modul 24 gemessen wird. Bei der Messung des Gleichspannungsversatzes des Quadraturmodulators 6 wird die Eingangsleistung auf Null heruntergeregelt, so dass das Signal in dem Pfad zwischen dem Phasenrotator 23 und dem 'Modulator DC-offset Korrektur'-Block 24 den DC-Offset des Modulators 6 repräsentiert. Der ermittelte Wert des DC-Offset wird im Register 34 gespeichert.

Mögliche Schaltstöße beim Umschalten vom Proportional-Mode in den Direkt-Mode werden mit Hilfe der Logik-Steuerung 39 vermieden.

Durch die jederzeit optimierten DC-Offsets ergibt sich eine optimale Restträgerunterdrückung des Systems sowohl im Direkt-Mode als auch im Proportional-Mode, weshalb die Rampen-Dynamik größer als 60 dB ist. Der Integrator 21 wird im Direkt-Mode initalisiert, so dass beim Umschalten des Schaltelements 30 ein nahtloses Umschalten erfolgt. Im Vergleich zu dem aus der WO 01/24467 A2 bekannten analogen System wird der Ausgang des Integrators 21 niemals gegen eine Begrenzung, wie bei der Spannungsbegrenzung der bei dem anologen System verwendeten Operationsverstärker, laufen.

## Patentansprüche

1. Sendeeinrichtung (1) mit einem digitalen Signalprozessor (DSP) (2) zur Bereitstellung eines komplexen Basisbandsignals, einer Verarbeitungseinheit (3) zur digitalen Ausregelung von in die Sendeeinrichtung (1) zurück gekoppelten Antennenreflexionen in Abhängigkeit des komplexen Basisbandsignals und eines von einem Analog-Digital-Wandler (16) erzeugten digitalen Signals eines analogen Ausgangssignals eines Quadraturdemodulators (15), einem Digital-Analog-Wandler (4) zur Umsetzung eines von der Verarbeitungseinheit (3) erzeugten digitalen Regelsignals in ein analoges Regelsignal, einem Quadraturmodulator (6) zur Quadraturmodulation des digitalen Regelsignals und zur Erzeugung eines Hochfrequenzsignals, einem Leistungsverstärker (9) zur Leistungsverstärkung des Hochfrequenzsignals und dem Quadraturdemodulator (15) zur Quadraturdemodulation des Ausgangssignals des Leistungsverstärkers (9) verstärkten Hochfrequenzsignals,
wobei die Verarbeitungseinheit (3) zur digitalen Ausregelung der in die Sendeeinrichtung (1) zurückgekoppelten Antennenreflexionen einen Integrator (21), aufweist.

2. Sendeeinrichtung nach Anspruch 1,
**dadurch gekennzeichnet,**
**dass** die Verarbeitungseinheit (3) eine Interpolationseinheit (18) zur Erzeugung einer interpolierten Inphase-Komponente (I SOLL) mittels Interpolation der Inphase-Komponente (I) und zur Erzeugung einer interpolierten Quadratur-Komponente (Q SOLL) mittels Interpolation der Quadratur-Komponente (Q) des vom digitalen Signalprozessor (2) bereitgestellten komplexen Basisbandsignals aufweist.

3. Sendeeinrichtung nach Anspruch 1 oder 2,
**dadurch gekennzeichnet,**
**dass** die Verarbeitungseinheit (3) eine erste Korrektureinheit (25) zur Erzeugung einer korrigierten Inphase-Komponente (I Korr) mittels Korrektur des Gleichspannungsversatzes der Inphase-Komponente (I Demod) des Ausgangssignals des Quadraturdemodulators (15) und zur Erzeugung einer korrigierten Quadratur-Komponente (Q Korr) mittels Korrektur des Gleichspannungsversatzes der Quadratur-Komponente (Q Demod) des Ausgangssignals des Quadraturdemodulators (15) aufweist.

4. Sendeeinrichtung nach Anspruch 3,
**dadurch gekennzeichnet,**
**dass** die Verarbeitungseinheit (3) eine Differenzbildungseinheit (22) aufweist, welche die Differenz (I Diff) aus der interpolierten Inphase-Komponente (I SOLL) und der korrigierten Inphase-Komponente (I Korr) und die Differenz (Q Diff) aus der interpolierten Quadratur-Komponente (Q SOLL) und der korrigierten Quadratur-Komponente (Q Korr) bildet.

5. Sendeeinrichtung nach Anspruch 4,
**dadurch gekennzeichnet,**
**dass** die Verarbeitungseinheit (3) eine Regeleinheit (20) aufweist, welche die Differenz (I Diff) der interpolierten Inphase-Komponente (I SOLL) des komplexen Basisbandsignals und der korrigierten Inphase-Komponente (I Korr) des Quadraturdemodulators (15) und die Differenz (Q Diff) der interpolierten Quadraturphase-Komponente (Q SOLL) des komplexen Basisbandsignals und der korrigierten Quadratur-Komponente (Q Korr) des Quadraturdemodulators (15) als Eingangssignal erhält und daraus eine proportionale Regelgröße (RG_{P}) erzeugt.

6. Sendeeinrichtung nach Anspruch 5,
**dadurch gekennzeichnet,**
**dass** der Integrator (21) die Regelgröße (RG_{P}) der Regeleinheit (20) integriert oder aufaddiert.

7. Sendeeinrichtung nach einem der Ansprüche 1 bis 6,
**dadurch gekennzeichnet,**
**dass** die Verarbeitungseinheit (3) eine zweite Korrektureinheit (24) zur Erzeugung einer korrigierten Inphase-Komponente (I Mod) und einer korrigierten Quadratur-Komponente (Q Mod) des von der Verarbeitungseinheit (3) erzeugten digitalen Regelsignals zur Korrektur des Gleichspannungsversatzes des Quadraturmodulators (6) aufweist.

8. Sendeeinrichtung nach einem der Ansprüche 1 bis 7,
**dadurch gekennzeichnet,**
**dass** die Verarbeitungseinheit (3) eine Phasenrotationseinheit (23) aufweist, welche mit dem Ausgangssignal des Integrators (21) eine Phasenrotation durchführt.

9. Sendeeinrichtung nach Anspruch 8,
**dadurch gekennzeichnet,**
**dass** die Verarbeitungseinheit (3) einen Phasen-Detektor (26) zur Bestimmung eines Phasenkorrekturwertes (Ph_Koeff) aus der korrigierten Inphase-Komponente (I Korr) des Quadraturdemodulators (15) und der korrigierten Quadratur-Komponente (Q Korr) des Quadraturdemodulators (15) aufweist, wobei dieser Phasenkorrekturwert (Ph_Koeff) der Phasenrotationseinheit (23) zugeführt ist.

10. Verfahren zum Betreiben einer Sendeeinrichtung (1) zur digitalen Ausregelung der in die Sendeeinrichtung (1) zurückgekoppelten Antennenreflexionen mit folgenden Verfahrensschritten:
- Erzeugen eines komplexen Basisbandsignals,
- Ermitteln eines Regelsignals in Abhängigkeit des komplexen Basisbandsignals und eines von einem Quadraturdemodulator (15) erzeugten Ausgangssignals,
- Erzeugen eines Hochfrequenzsignals mittels Quadraturmodulieren des Regelsignals,
- Quadraturdemodulieren des Hochfrequenzsignals,
- Erzeugen einer korrigierten Inphase-Komponente (I Korr) des Ausgangssignals des Quadraturdemodulators (15) mittels Korrektur des Gleichspannungsversatzes einer Inphase-Komponente (I Demod) des Ausgangssignals des Quadraturdemodulators (15) und Erzeugen einer korrigierten Quadratur-Komponente (Q Korr) des Ausgangssignals des Quadraturdemodulators (15) mittels Korrektur des Gleichspannungsversatzes der Quadraturphase-Komponente (Q Demod) des Ausgangssignals des Quadraturdemodulators (15),
- Bestimmung des Phasenkorrekturwertes (Ph_Koeff) aus der korrigierten Inphase-Komponente (I Korr) des Ausgangssignals des Quadraturdemodulators (15) und der korrigierten Quadratur-Komponente (Q Korr) des Ausgangssignals des Quadraturdemodulators (15), und
- Korrektur einer Inphase-Komponente und einer Quadratur-Komponente des Regelsignals um einen Phasenkorrekturwert (Ph_Koeff),
wobei die Verarbeitung des Phasenkorrekturwertes (Ph_Koeff) zur Durchführung der Phasenkorrektur digital erfolgt, und
wobei das Regelsignal zur digitalen Ausregelung der in die Sendeeinrichtung (1) zurück gekoppelten Antennenreflexionen mittels Integrieren einer Differenz zwischen dem komplexen Basisbandsignal und des vom Quadraturdemodulator (15) erzeugten Ausgangssignals ermittelt wird.

11. Verfahren nach Anspruch 10,
**dadurch gekennzeichnet,**
**dass** die Inphase-Komponente und die Quadratur-Komponente des Regelsignals vor der Einspeisung in einen Quadraturmodulator (6) um einen Gleichspannungsversatz korrigiert werden, wobei die Korrekturwerte (Off_Corr_M1, Off_Corr_M2) immer am Ende eines Sendeintervalls neu ermittelt werden.

12. Verfahren nach Anspruch 11,
**dadurch gekennzeichnet,**
**dass** die korrigierte Inphase-Komponente (I Korr) und die korrigierte Quadratur-Komponente (Q Korr) des Ausgangssignals des Quadraturdemodulators (15) durch eine Korrektur um einen Gleichspannungsversatz aus der demodulierten Inphase-Komponente (I Demod) und der demodulierten Quadratur-Komponente (Q Demod) des Ausgangssignals des Quadraturdemodulators (15) gewonnen werden, wobei die Ermittlung zu Beginn eines jeden Sendeintervalls erfolgt.

13. Verfahren nach einem der Ansprüche 10 bis 12,
**dadurch gekennzeichnet,**
**dass** vor der Phasenkorrektur aus einer Differenz (I Diff) der Inphase-Komponente (I SOLL) des komplexen Basisbandsignals und der korrigierten Inphase-Komponente (I Korr) des Ausgangssignals des Quadraturdemodulators (15) sowie aus einer Differenz (Q Diff) der Quadratur-Komponente (Q SOLL) des komplexen Basisbandsignals und der korrigierten Quadraturphase-Komponente (Q Korr) des Ausgangssignals des Quadraturdemodulators (15) eine Regelgröße (RG_{P}) gewonnen wird.

## Claims

1. Transmitting device (1) having a digital signal processor (DSP) (2) for provision of a complex base band signal, a processing unit (3) for digital control of antenna reflections fed back into the transmitting device (1) depending on the complex base band signal and a digital signal produced by an analogue-to-digital converter (16) from an analogue output signal of a quadrature demodulator (15), a digital-to-analogue converter (4) for converting a digital control signal produced by the processing unit (3) into an analogue control signal, a quadrature modulator (6) for quadrature modulation of the digital control signal and for producing a high-frequency signal, a power amplifier (9) for amplifying the power of the high-frequency signal, and the quadrature demodulator (15) for quadrature demodulation of the amplified high-frequency signal of the output signal of the power amplifier (9),
wherein the processing unit (3) for digital control of the antenna reflections fed back into the transmitting device (1) has an integrator (21).

2. Transmitting device according to claim 1,
**characterised in that** the processing unit (3) has an interpolation unit (18) for producing an interpolated in-phase component (I SOLL) by means of interpolation of the in-phase component (I) and for producing an interpolated quadrature component (Q SOLL) by means of interpolation of the quadrature component (Q) of the complex base band signal provided by the digital signal processor (2).

3. Transmitting device according to claim 1 or 2,
**characterised in that** the processing unit (3) has a first correction unit (25) for producing a corrected in-phase component (I Korr) by means of correction of the DC voltage offset of the in-phase component (I Demod) of the output signal of the quadrature demodulator (15) and for producing a corrected quadrature component (Q Korr) by means of correction of the DC voltage offset of the quadrature component (Q Demod) of the output signal of the quadrature demodulator (15).

4. Transmitting device according to claim 3,
**characterised in that** the processing unit (3) has a difference forming unit (22) which forms the difference (I Diff) from the interpolated in-phase component (I SOLL) and the corrected in-phase component (I Korr) and the difference (Q Diff) from the interpolated quadrature component (Q SOLL) and the corrected quadrature component (Q Korr).

5. Transmitting device according to claim 4,
**characterised in that** the processing unit (3) has a control unit (20) which receives the difference (I Diff) of the interpolated in-phase component (I SOLL) of the complex base band signal and the corrected in-phase component (I Korr) of the quadrature demodulator (15) and the difference (Q Diff) of the interpolated quadrature phase component (Q SOLL) of the complex base band signal and the corrected quadrature component (Q Korr) of the quadrature demodulator (15) as input signal and produces a proportional control variable (RG_{P}) therefrom.

6. Transmitting device according to claim 5,
**characterised in that** the integrator (21) integrates or adds the control variable (RGₚ) of the control unit (20).

7. Transmitting device according to one of claims 1 to 6,
**characterised in that** the processing unit (3) has a second correction unit (24) for producing a corrected in-phase component (I Mod) and a corrected quadrature component (Q Mod) of the digital control signal produced by the processing unit (3) for correcting the DC voltage offset of the quadrature modulator (6).

8. Transmitting device according to one of claims 1 to 7,
**characterised in that** the processing unit (3) has a phase rotation unit (23) which carries out a phase rotation with the output signal of the integrator (21).

9. Transmitting device according to claim 8,
**characterised in that** the processing unit (3) has a phase detector (26) for determining a phase correction value (Ph_Koeff) from the corrected in-phase component (I Korr) of the quadrature demodulator (15) and the corrected quadrature component (Q Korr) of the quadrature demodulator (15), wherein this phase correction value (Ph_Koeff) is fed to the phase rotation unit (23).

10. Method for operating a transmitting device (1) for digital control of the antenna reflections fed back into the transmitting device (1) with the following method steps:
- production of a complex base band signal,
- determination of a control signal depending on the complex base band signal and of an output signal produced by a quadrature demodulator (15),
- production of a high-frequency signal by means of quadrature modulation of the control signal,
- quadrature demodulation of the high-frequency signal,
- production of a corrected in-phase component (I Korr) of the output signal of the quadrature demodulator (15) by means of correction of the DC voltage offset of an in-phase component (I Demod) of the output signal of the quadrature demodulator (15) and production of a corrected quadrature component (Q Korr) of the output signal of the quadrature demodulator (15) by means of correction of the DC voltage offset of the quadrature phase component (Q Demod) of the output signal of the quadrature demodulator (15),
- determination of the phase correction value (Ph_Koeff) from the corrected in-phase component (I Korr) of the output signal of the quadrature demodulator (15) and the corrected quadrature component (Q Korr) of the output signal of the quadrature demodulator (15), and
- correction of an in-phase component and a quadrature component of the control signal by a phase correction value (Ph_Koeff),
wherein the processing of the phase correction value (Ph_Koeff) for carrying out the phase correction is effected digitally, and
wherein the control signal for digital control of the antenna reflections fed back into the transmitting device (1) is determined by means of integration of a difference between the complex base band signal and the output signal produced by the quadrature demodulator (15).

11. Method according to claim 10,
**characterised in that** the in-phase component and the quadrature component of the control signal are corrected by a DC voltage offset before being fed into a quadrature modulator (6), wherein the correction values (Off_Corr_M1, Off_Corr_M2) are always determined anew at the end of a transmission interval.

12. Method according to claim 11,
**characterised in that** the corrected in-phase component (I Korr) and the corrected quadrature component (Q Korr) of the output signal of the quadrature demodulator (15) are obtained by a correction by a DC voltage offset from the demodulated in-phase component (I Demod) and the demodulated quadrature component (Q Demod) of the output signal of the quadrature demodulator (15), wherein the determination is effected at the beginning of each transmission interval.

13. Method according to one of claims 10 to 12,
**characterised in that** before the phase correction a control variable (RGₚ) is obtained from a difference (I Diff) of the in-phase component (I SOLL) of the complex base band signal and the corrected in-phase component (I Korr) of the output signal of the quadrature demodulator (15) and from a difference (Q Diff) of the quadrature component (Q SOLL) of the complex base band signal and the corrected quadrature phase component (Q Korr) of the output signal of the quadrature demodulator (15).

## Revendications

1. Dispositif d'émission (1) comprenant un processeur de signal numérique (DSP) (2) permettant la fourniture d'un signal de bande de base complexe, une unité de traitement (3) permettant la régulation numérique de réflexions d'antenne renvoyées dans le dispositif d'émission (1) en fonction du signal de bande de base complexe et d'un signal numérique, d'un signal de sortie numérique d'un démodulateur en quadrature (15), généré par un convertisseur analogique-numérique (16), un convertisseur numérique-analogique (4) permettant la conversion d'un signal de régulation numérique généré par l'unité de traitement (3) en un signal de régulation analogique, un modulateur en quadrature (6) permettant la modulation en quadrature du signal de régulation numérique et la génération d'un signal haute fréquence, un amplificateur de puissance (9) permettant d'amplifier la puissance du signal haute fréquence et le démodulateur en quadrature (15) permettant la démodulation en quadrature du signal de sortie du signal haute fréquence amplifié par l'amplificateur de puissance (9),
dans lequel l'unité de traitement (3) comprend un intégrateur (21) pour la régulation numérique des réflexions d'antenne renvoyées dans le dispositif d'émission (1).

2. Dispositif d'émission selon la revendication 1,
**caractérisé**
**en ce que** l'unité de traitement (3) comprend une unité d'interpolation (18) permettant de générer une composante en phase interpolée (I SOLL) par interpolation de la composante en phase (I) et permettant de générer une composante de quadrature interpolée (Q SOLL) par interpolation de la composante de quadrature (Q) du signal de bande de base complexe fourni par le processeur de signal numérique (2).

3. Dispositif d'émission selon la revendication 1 ou 2,
**caractérisé**
**en ce que** l'unité de traitement (3) comprend une première unité de correction (25) destinée à générer une composante en phase corrigée (I Korr) par correction du décalage de tension continue de la composante en phase (I Demod) du signal de sortie du démodulateur en quadrature (15) et à générer une composante de quadrature corrigée (Q Korr) par correction du décalage de tension continue de la composante de quadrature (Q Demod) du signal de sortie du démodulateur en quadrature (15).

4. Dispositif d'émission selon la revendication 3,
**caractérisé**
**en ce que** l'unité de traitement (3) comprend une unité de formation de différence (22), laquelle forme la différence (I Diff) entre la composante en phase interpolée (I SOLL) et la composante en phase corrigée (I Korr) et la différence (Q Diff) entre la composante de quadrature interpolée (Q SOLL) et la composante de quadrature corrigée (Q Korr).

5. Dispositif d'émission selon la revendication 4,
**caractérisé**
**en ce que** l'unité de traitement (3) comprend une unité de régulation (20), laquelle reçoit la différence (I Diff) de la composante de phase interpolée (I SOLL) du signal de bande de base complexe et la composante en phase corrigée (I Korr) du démodulateur en quadrature (15) et la différence (Q Diff) entre la composante de phase de quadrature interpolée (Q SOLL) du signal de bande de base complexe et la composante de quadrature corrigée (Q Korr) du démodulateur en quadrature (15) en tant que signal d'entrée et génère à partir de celle-ci une grandeur réglée proportionnelle (RG_{P}).

6. Dispositif d'émission selon la revendication 5,
**caractérisé**
**en ce que** l'intégrateur (21) intègre ou additionne la grandeur réglée (RG_{P}) de l'unité de régulation (20).

7. Dispositif d'émission selon l'une quelconque des revendications 1 à 6,
**caractérisé**
**en ce que** l'unité de traitement (3) comprend une deuxième unité de correction (24) destinée à générer une composante en phase corrigée (I Mod) et une composante de quadrature corrigée (Q Mod) du signal de régulation numérique généré par l'unité de traitement (3) pour corriger le décalage de tension continue du démodulateur en quadrature (6).

8. Dispositif d'émission selon l'une quelconque des revendications 1 à 7,
**caractérisé**
**en ce que** l'unité de traitement (3) comprend une unité de rotation de phase (23), laquelle réalise une rotation de phase avec le signal de sortie de l'intégrateur (21).

9. Dispositif d'émission selon la revendication 8,
**caractérisé**
**en ce que** l'unité de traitement (3) comprend un détecteur de phase (26) destiné à déterminer une valeur de correction de phase (Ph-Koeff) à partir de la composante en phase corrigée (I Korr) du démodulateur en quadrature (15) et de la composante de quadrature corrigée (Q Korr) du démodulateur en quadrature (15), dans lequel cette valeur de correction de phase (Ph_Koeff) est amenée à l'unité de rotation de phase (23).

10. Procédé permettant de faire fonctionner un dispositif d'émission (1) pour la régulation numérique des réflexions d'antenne renvoyées dans le dispositif d'émission (1), comprenant les étapes de procédé suivantes :
- générer un signal de bande de base complexe,
- déterminer un signal de régulation en fonction du signal de bande de base complexe et d'un signal de sortie généré par un démodulateur en quadrature (15),
- générer un signal haute fréquence par modulation en quadrature du signal de régulation,
- démoduler en quadrature le signal haute fréquence,
- générer une composante en phase corrigée (I Korr) du signal de sortie du démodulateur en quadrature (15) par correction du décalage de tension continue d'une composante en phase (I Demod) du signal de sortie du démodulateur en quadrature (15) et générer une composante de quadrature corrigée (Q Korr) du signal de sortie du démodulateur en quadrature (15) par correction du décalage de tension continue de la composante de phase de quadrature (Q Demod) du signal de sortie du démodulateur en quadrature (15),
- déterminer la valeur de correction de phase (Ph_Koeff) à partir de la composante en phase corrigée (I Korr) du signal de sortie du démodulateur en quadrature (15) et de la composante de quadrature corrigée (Q Korr) du signal de sortie du démodulateur en quadrature (15), et
- corriger une composante en phase et une composante de quadrature du signal de régulation d'une valeur de correction de phase (Ph_Koeff),
dans lequel le traitement de la valeur de correction de phase (Ph_Koeff)intervient numériquement pour réaliser la correction de phase, et
dans lequel le signal de régulation, permettant la régulation numérique des réflexions d'antenne renvoyées dans le dispositif d'émission (1) par intégration d'une différence entre le signal de bande de base complexe et le signal de sortie généré par le démodulateur en quadrature (15), est déterminé.

11. Procédé selon la revendication 10,
**caractérisé**
**en ce que** la composante en phase et la composante de quadrature du signal de régulation sont corrigées d'un décalage de tension continue avant l'injection dans un modulateur de quadrature (6), dans lequel les valeurs de correction (Off_Corr_M1, Off_Corr_M2) sont à nouveau déterminées, toujours à la fin d'un intervalle d'émission.

12. Procédé selon la revendication 11,
**caractérisé**
**en ce que** la composante en phase corrigée (I Korr) et la composante de quadrature corrigée (Q Korr) du signal de sortie du démodulateur en quadrature (15) sont obtenues par une correction d'un décalage de tension continue entre la composante en phase démodulée (I Demod) et la composante de quadrature démodulée (Q Demod) du signal de sortie du démodulateur en quadrature (15), dans lequel la détermination intervient au début de chaque intervalle d'émission.

13. Procédé selon l'une quelconque des revendications 10 à 12,
**caractérisé**
**en ce que**, avant la correction de phase, une grandeur régulée (RG_{P}) est obtenue à partir d'une différence (I Diff) entre la composante en phase (I SOLL) du signal de bande de base complexe et la composante en phase corrigée (I Korr) du signal de sortie du démodulateur en quadrature (15) ainsi qu'à partir d'une différence (Q Diff) entre la composante de quadrature (Q SOLL) du signal de bande de base complexe et la composante de phase de quadrature corrigée (Q Korr) du signal de sortie du démodulateur en quadrature (15).
